# EUROPEAN PATENT APPLICATION

(11) **EP 1 624 311 A1**
(43) Date of publication of application: **08.02.2006**
(21) Application number: 04425619.6
(22) Date of filing: 06.08.2004
(51) Int. Cl.: G01R 15/06

(54) **Combined current and voltage measurement transformer of the capacitor bushing type**

(71) Applicant: Passoni & Villa Fabbrica Isolatori e Condensatori S.p.A., 20162 Milano (IT)
(72) Inventor: Villa, Giorgio, 20124 Milan (MI) (IT); Villa, Giancarlo, 20123 Milan (MI) (IT)
(74) Representative: Parisi, Luigi

(57) **Abstract**

Electronic combined current and voltage measurement device of the capacitor bushing type comprising a sealed assembly formed by an upper insulating casing (11) that supports a head (10) and a flange (7), said sealed unit being completed by a lower insulating casing (12) and by a lower base (13). Contained inside said unit is a metal tube (1) connected to a conductor through which a primary current passes and a capacitor bushing suitably produced to reduce the output voltage to values in line with the power supply of electronic voltage measurement devices. In the invention, the current signal is picked up by Rogowsky coils (14) positioned inside the flange (7) and supplied in Low Voltage from the power supply (15), converted into a digital signal by an electro-optical converter (8) and subsequently sent, by means of optical fibers (9), to electronic measurement and protection devices located in the control room of the power station. The voltage signal is picked up by the capacitive divider derived from the capacitor bushing and converted into digital signal and then into electro-optical signal.

## Description

The present invention relates to a combined current and voltage measurement transformer of the capacitor bushing type (hereinafter "electronic combined current and voltage measurement device of the capacitor bushing type").

A first type of prior art combined measurement device utilizes electro-optical transformers.

These devices measure the current by making use of magneto-optical effects and the voltage by making use of electro-optical effects, suitably transforming the electric signals coming from the network into optical signals to process and analyze them consequently.

In particular, the current transformers utilized therein operate making use of the "Faraday" effect.

According to the Faraday effect, a magnetic field influences the polarization of a ray of monochromatic light which passes through a transparent optical means.

In the specific case, the magnetic field is produced by the current circulating on the line that passes through the transformer.

The light intensity is linked to the current value through a known mathematical relation.

Voltage transformers operate making use of the Pockels effect, according to which an electric field is capable of influencing the optical behavior - in particular the refraction index - of a crystal through which a light ray passes.

In the specific case the electric field will be proportional to the voltage of the power line.

Also in this case there is a known mathematical relation between the light intensity and the voltage value.

This type of prior art device has to date be employed experimentally on a limited number of transformers.

A barrier for placing these combined measurement devices on the market is without doubt represented by the production costs, which can be compared to those of traditional transformers with consolidated reliability.

A second type of prior art classic combined measurement device is constituted by an inductive transformer to measure voltage, generally fitted on the head of a current transformer and having isolation to ground in common therewith.

In current transformers employed to produce the aforesaid combined measurement devices, the primary winding is constituted by one of the conductors of the power line while the secondary windings, suitably insulated, are constituted by coils wound on toroidal magnetic cores.

Insulation between the primary and secondary winding is generally produced by means of pressurized gas or oil/paper.

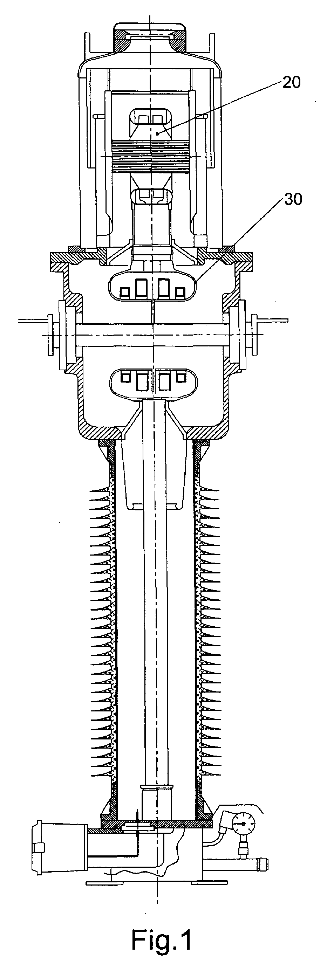

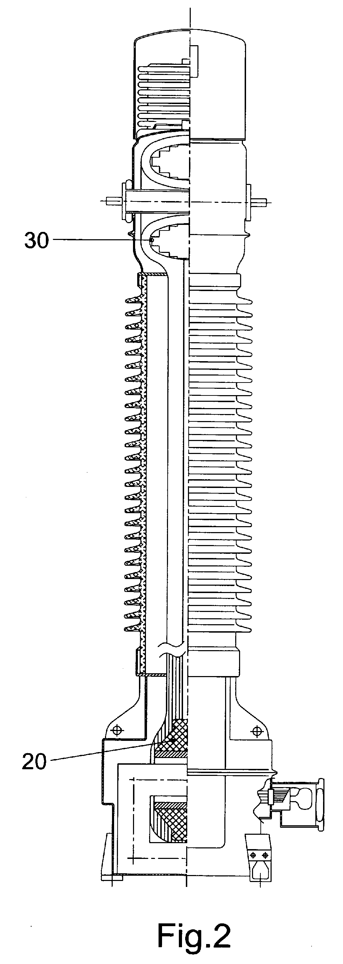

The second type of prior art classic combined device is shown schematically in Figures 1 and 2.

Figure 1 shows, by way of an example, a combined measurement device in the case in which insulation is produced with pressurized gas; in this configuration an inductive transformer 20 is inserted on the head of a current transformer 30.

Figure 2 instead shows a combined measurement device wherein the insulation means is constituted by oil/paper; in this configuration the inductive transformer 20 for voltage measurement generally may be positioned in the lower part of the body of the combined device.

Devices belonging to said second type of classic combined measurement devices have the following weak points:
- all inductive transformers are "easily saturable" and therefore in the case of overcurrents/overvoltages the measurement and protection signals are distorted with the possibility of dangerous ferroresonance effects;
- combined devices are very heavy with consequent problems of transport, assembly and during operation in concurrence with seismic phenomena as the most important masses are positioned in the upper part of the object;
- the decrease in costs with respect to the sum of the two transformers considered separately is insignificant and only justifies their use in specific markets where reducing spaces is a priority.

In prior art there are also combined measurement devices of the capacitor bushing type wherein the voltage signals are taken from the capacitor bushing and the current signals are supplied by toroidal transformers disposed around the flange of said bushing.

These combined measurement devices cannot satisfy the requested combination requirements because, to send the voltage signal to the electromagnetic devices, they require ancillary equipment with large dimensions, such as step-down transformers and inductive reactors that can resound with the capacitance of the capacitor; this equipment is usually installed in proximity to the bushing and is connected thereto by cable. It cannot be housed inside the capacitor bushing flange to form a single instrument and thereby leads to extremely costly and low performance solutions.

For the current signals, the toroidal transformers are housed around the lower part, for example on the transformer side, or upper part, for example on the air, cable or gas insulated side, of the bushing and owing to their dimensions require noteworthy extensions of the flange connected to ground, either in the lower part or in the upper part, with consequent modification of the capacitor inside the bushing and a considerable increase in dimensions, weight and hence of the total costs.

Neither of these devices can be integrated in the flange of the bushing such as those described in the present invention.

The object of the present invention is to solve the aforesaid problems by making use of the existence of the capacitor bushing insulators already present in power stations and sub-stations, to produce an electronic combined current and voltage measurement device that in Low Voltage makes both the voltage signal and the current signal available, which is compatible with the performances and precision classes defined in the Standards for electronic type voltage and current measurement transformers.

A further object of the present invention is to produce a device with moderate costs and smaller overall dimensions with respect to prior art combined devices.

These objects are attained by a combined current and voltage measurement device of the capacitor bushing type, as claimed in claim 1, which should be referred to for brevity.

The invention is described in detail hereunder, by way of a non-limiting example, with reference to the accompanying drawings, wherein:
- Figure 1 shows a sectional view of a combined current and voltage measurement device, according to a first prior art type;
- Figure 2 shows a sectional view of a combined current and voltage measurement device, according to a second prior art type;

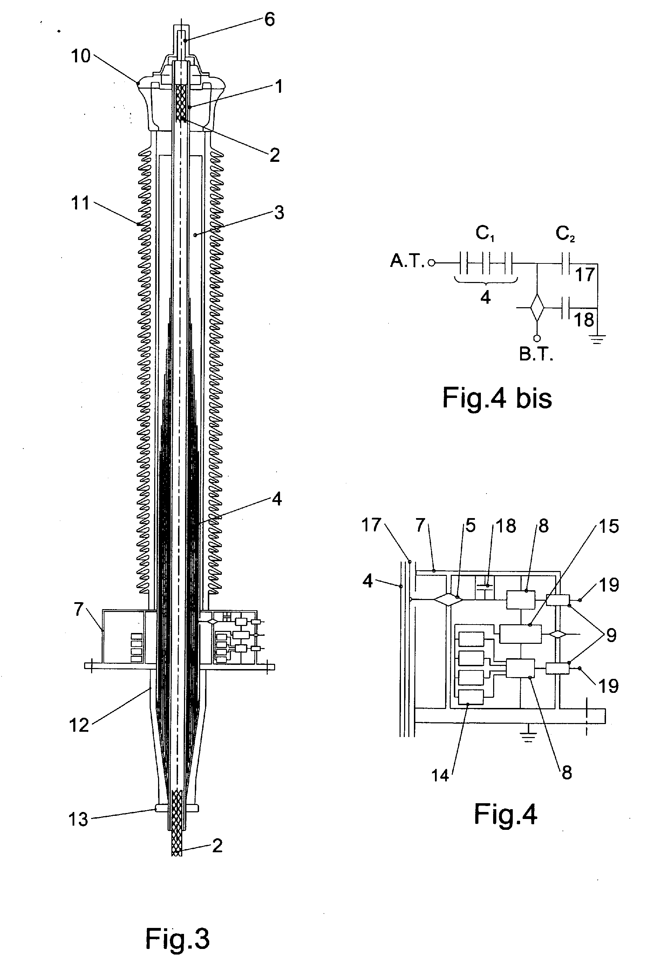

- Figure 3 shows a sectional view of a combined current and voltage measurement device of the capacitor bushing type, according to the present invention;
- Figure 4 shows a sectional view of a detail illustrating the instruments of the combined measurement device according to the present invention; and
- Figure 4bis is a wiring diagram of a voltage divider of the present invention.

The combined measurement device of the present invention is indicated as a whole, in an exemplifying embodiment, in Figure 3.

It comprises a metal tube 1, inside which a braid 2 or a fixed or removable pin may be introduced to connect the High Voltage network, through a terminal 6, to the electric power apparatus, generally constituted by a transformer.

A capacitor bushing formed of an insulating body 3, constituted by dielectric layers intercalated with a plurality of metal armatures 4 or semiconductors, is wound on said tube 1.

The series of said armatures constitutes the HV capacitance C1 of a divider composed of said capacitance and of the LV capacitance C2 formed by the parallel of the capacitance to ground of the last armature 17 and by the auxiliary capacitance 18, the LV lead 5 being insulated from ground to pick up the voltage signal (Figure 4b).

The assembly composed of the tube 1 and of the capacitor bushing is enclosed in a sealed unit, comprising an upper insulating casing 11, a lower casing 12, a flange 7, a head 10 and a lower base 13.

As shown in Figure 4, one or more Rogowsky coils 14, a power supply 15 and the electro-optical converters 8 connected at the output to connectors 9 of the optical fiber or fibers 19 are contained inside said flange 7.

During operation of the electronic combined current and voltage measurement device of the capacitor bushing type, the device that allows current measurement is enclosed inside said flange 7.

In particular the current signal, proportional to the primary network current, is picked up by one or more Rogowsky coils 14, supplied in Low Voltage by the power supply 15.

The digital current signal proportional to the current to be measured is transformed into a light signal by the electro-optical converter 8 and subsequently sent, by means of optical fibers 19 leading from the connector 9, to electronic measurement and protection devices located in the control room of the power station or substation, after opto-electric conversion.

Instead, with regard to the methods of measuring voltage, the signal is picked up through the voltage divider formed by the capacitances in series of the armatures 4 and by the capacitance formed by the parallel of the capacitance to ground of the outer armature 17 and of the auxiliary capacitance 18, insulated to ground by the LV lead 5.

This solution therefore configures a voltage divider suitably produced to reduce the output voltage to the value of a few Volts.

The capacitor bushing may be produced with any type of technology currently in use and with the various dielectrics normally used in the manufacture thereof.

In operation of the invention, the analog voltage signal to be measured is converted into a digital signal and then transformed into a light signal by the converter 8 and subsequently sent by means of the optical fibers 19 leading out from the connector 9 to electronic measurement and protection devices located in the control room of a power station or substation, after opto-electronic reconversion.

This combined bushing device indicated in Figure 3 can today be produced thanks to the reduced ratings requested by the standards for supplying power to electronic voltage and current measurement systems and thanks to the low consumption of its relays for electronic protection.

The optical fiber or fibers 19 leading out from the connector 9 permit distant transmission of the signal, guaranteeing perfect galvanic isolation.

The combined measurement device of the present invention has numerous and important advantages with respect to the devices utilized in prior art.

In the first place, with the aforesaid device the signals are made available in LV and can be available digitally or converted from analog to digital, then transformed into light signals by electro-optical transducers, in a simple and reliable way. The optical fibers can transmit the signal to a distance guaranteeing perfect galvanic isolation. Reconstruction of the voltage and current signals occurs passing through the opto-electric converters and, if necessary, through digital-analog converters.

Finally, this is a highly reliable device obtainable at moderate costs.

From the description hereinbefore, it is apparent that the inventive concepts expressed are not limited to the applicative examples illustrated, but may be advantageously adapted to other analogous applications.

The field of use of the present invention is not limited to the examples indicated in the description hereinbefore.

By way of example, other applications may utilize capacitor bushings, such as wall and floor bushings, bushings that connect gas or oil switches, gas insulated substations and the like to the HV network.

The present invention is therefore susceptible to numerous modifications or variants all coming within the inventive concept expressed in the appended claims, while the technical details may vary according to needs.

## Claims

1. Electronic combined current and voltage measurement device of the capacitor bushing type, comprising a sealed unit formed of an upper insulating casing (11), of a head (10), of a flange (7), of a lower insulating casing (12), closed at the bottom by the base (13), where contained inside said unit is at least one metal tube (1), connected to a conductor (2) through which the network current to be measured passes, wound on which is an insulating body (3), inside which a plurality of metal armatures (4) are inserted, **characterized in that** amperometric measurement is performed by one or more Rogowsky coils (14) arranged in the flange (7) from which the current signals are picked up for relative measurement and to activate the electronic protection relays and **in that** the voltage is measured by making use of the capacitive divider formed by the HV capacitance constituted by the series of armatures (4) and by the LV capacitance produced by the parallel of the capacitance formed by the last armature to ground and of an auxiliary capacitance (18) in order to reduce the output voltage to values in line with the power supply of electronic devices to measure the voltage and to operate the electronic protection devices.

2. Combined measurement device as claimed in claim 1, **characterized in that** at least one Rogowsky coil (14) is supplied in Low Voltage by a power supply (15) positioned inside said flange (7).

3. Combined measurement device as claimed in the previous claims, **characterized in that** it comprises an electro-optical converter (8), generally positioned inside said flange (7), to transform the electric signal into an optical signal.

4. Combined measurement device as claimed in the previous claims, **characterized in that** it comprises optical fibers (19) for distant and galvanically insulated transmission of the optical signal from said electro-optical converter (8) to electronic measurement and protection devices after opto-electric reconversion.

5. Combined measurement device as claimed in the previous claims, **characterized in that** insulation of the capacitor body may be produced utilizing any type of insulating material currently employed in prior art filled with traditional fluids or resins.

6. Combined measurement device as claimed in the previous claims utilized solely to pick up one of the available signals.

## Amended claims

### Amended claims in accordance with Rule 86(2) EPC.

**1.** Electronic combined current and voltage measurement device, of H.V. capacitance graded bushing type, **characterized by** a sealed unit formed by an upper insulating envelope (11) a head (10), a flange enclosure (7), a lower insulating casing (12), closed at the bottom by a metal ring (13) where, inside said unit, a H.V. capacitance graded bushing (3) wound on a metal tube (1), connected to the conductor (2), with the series of capacitance C₁ formed by the metal foils (4), duly insulated between them and the capacitance of the last foil (17) to the flange enclosure (7), paralled eventually by an auxiliary capacitance (18), behaves as a voltage divider, that through the tap (5) gives a low voltage analog signal, proportional to the high voltage value to be measured and to be sent, after conversion from analog to opto-digital (8b) signal, via fiber optic link (19), to the control bay of a Power Station or Substation, and where the analog current signal, proportional to the H.V. current value in the conductor (2), obtained by the Rogowsky coils (14), arranged in the flange enclosure (7) is sent, through the chain composed by an electro-optic converter (8a), fed by the L.V. power supply (15), and a fiber optic link (19), to the control bay as before.

**2.** Combined measuring device as claimed in claim 1, **characterized in that** further voltage and current signals, proportional to the voltage and current in H.V. side, can feed static relays for protection purpose.
